# EUROPEAN PATENT APPLICATION

(11) **EP 1 821 579 A2**
(43) Date of publication of application: **22.08.2007**
(21) Application number: 07001980.7
(22) Date of filing: 30.01.2007
(51) Int. Cl.: H05B 33/20

(54) **Light emitting element, light emitting device, and electronic appliance**

(30) Priority: 17.02.2006 JP 2006041636
(71) Applicant: SEMICONDUCTOR ENERGY LABORATORY CO., LTD., Atsugi-shi, Kanagawa-ken 243-0036 (JP)
(72) Inventor: Yamazaki, Shunpei, Atsugi-shi Kanagawa-ken 243-0036 (JP); Sakata, Junichiro, Atsugi-shi Kanagawa-ken 243-0036 (JP); Kawakami, Takahiro, Atsugi-shi Kanagawa-ken 243-0036 (JP); Yamamoto, Yoshiaki, Atsugi-shi Kanagawa-ken 243-0036 (JP); Katayama, Miki, Atsugi-shi Kanagawa-ken 243-0036 (JP); Yokoyama, Kohei, Atsugi-shi Kanagawa-ken 243-0036 (JP)
(74) Representative: Grünecker, Kinkeldey, Stockmair & Schwanhäusser Anwaltssozietät

(57) **Abstract**

It is an object to provide a light emitting element capable of low-voltage driving; with high luminous efficiency; with high emission luminance; and with long emission lifetime. It is another object to provide a light emitting device and an electronic appliance in which power consumption is reduced; and which can be manufactured at low cost. A light emitting element is provided, including a light emitting layer and a layer including a composite material between a first electrode and a second electrode, where the light emitting layer includes a base material and an impurity element, the layer including the composite material includes an organic compound and an inorganic compound, the layer including the composite material is provided to be in contact with the second electrode, and light emission is obtained by application of a voltage so that an electric potential of the second electrode is higher than that of the first electrode.

## Description

### BACKGROUND OF THE INVENTION

### 1. Field of the Invention

The present invention relates to a light emitting element utilizing electro luminescence. Moreover, the present invention relates to a light emitting device and an electronic appliance having a light emitting element.

### 2. Description of the Related Art

In recent years, a display device in a television, a mobile phone, a digital camera, or the like has been required to have a planar and thin shape. As a display device for satisfying the requirement, a display device utilizing a self-light emitting element has attracted attention. As one of self-light emitting elements, a light emitting element utilizing electro luminescence is given. In this light emitting element, a light emitting material is interposed between a pair of electrodes and a voltage is applied, whereby light emission from the light emitting material can be obtained.

Such a self-light emitting element has advantages such as higher visibility of a pixel than a liquid crystal display, and unnecessity of a backlight; therefore, it is considered that such a self-light emitting element is preferable as a flat panel display element. Further, such a light emitting element has another great advantage that it can be manufactured to be thin and lightweight. Further, extremely high response speed is also one of the features.

Such a self-light emitting element can be formed into a film shape. Thus, surface emission can be easily obtained by the formation of a large-area element. This characteristic is hard to be obtained in a point light source typified by an incandescent lamp or an LED or in a line light source typified by a fluorescent lamp. Therefore, the above-described light emitting element also has a high utility value as a surface light source which is applicable to lighting or the like.

The light emitting elements utilizing electro luminescence are distinguished from each other whether a light emitting material thereof is an organic compound or an inorganic compound. In general, the former is referred to as an organic EL element, and the latter is referred to as an inorganic EL element.

The inorganic EL elements are classified into a disperse type inorganic EL element and a thin film type inorganic EL element depending on its element structure. There is a difference between the two types of elements in that the former has a light emitting layer in which particles of a light emitting material are dispersed in a binder and the latter has a light emitting layer formed using a thin film of a fluorescent material. However, the mechanism is common; light emission is obtained by collision excitation of a base material or a luminescent center by an electron accelerated by a high electric field. From such a reason, a high electric field is necessary to obtain light emission in a general inorganic EL element, and a voltage of several hundred volts is required to be applied to the light emitting element. For example, an inorganic EL element, which emits blue light with high luminance required for a full color display, has developed in recent years; however, a drive voltage of 100 to 200 V is required (for example, Non-Patent Document 1: Japanese Journal of Applied Physics, 1999, Vol.38, p.L1291). Therefore, the inorganic EL element consumes high power and has been difficult to be employed for a small- or medium-sized display, for example, a display for a mobile phone or the like.

### SUMMARY OF THE INVENTION

In view of the foregoing problem, it is an object of the present invention to provide a light emitting element capable of low-voltage driving. It is another object to provide a light emitting element with high luminous efficiency, a light emitting element with high emission luminance, a light emitting element with long emission lifetime, a light emitting device and an electronic appliance in which power consumption is reduced, and a light emitting device and an electronic appliance which can be manufactured at low cost.

The present inventors have found that the objects can be solved by providing a layer including a composite material between electrodes.

One feature of the present invention is a light emitting element having a light emitting layer and a layer including a composite material between a first electrode and a second electrode, where the light emitting layer includes a base material (also called as a matrix material) and an impurity element, the layer including the composite material includes an organic compound and an inorganic compound, the layer including the composite material is provided to be in contact with the second electrode, and light emission is obtained by application of a voltage so that an electric potential of the second electrode is higher than an electric potential of the first electrode.

In the above structure, as the organic compound, it is preferable to use an aromatic amine compound, a carbazole derivative, or aromatic hydrocarbon.

In the above structure, the inorganic compound preferably shows an electron accepting property with respect to the organic compound. Specifically, transition metal oxide is preferable. In particular, an oxide of a metal belonging to Groups 4 to 8 in the periodic table is preferable. Further, any of vanadium oxide, niobium oxide, tantalum oxide, chromium oxide, molybdenum oxide, tungsten oxide, manganese oxide, and rhenium oxide is more preferable.

In the above structure, zinc sulfide, cadmium sulfide, calcium sulfide, yttrium sulfide, gallium sulfide, strontium sulfide, barium sulfide, zinc oxide, yttrium oxide, aluminum nitride, gallium nitride, indium nitride, zinc selenide, zinc telluride, calcium-gallium sulfide, strontium-gallium sulfide, barium-gallium sulfide, or the like can be used for the base material.

In the above structure, the impurity element is preferably a metal element to be a luminescent center. Further, preferably, plural kinds of the impurity elements are included, which are a metal element to be a luminescent center; any one of fluorine (F), chlorine (Cl), bromine (Br), iodine (I), boron (B), aluminum (Al), gallium (Ga), indium (In), and thallium (Tl); and any one of lithium (Li), sodium (Na), potassium (K), rubidium (Rb), cesium (Cs), nitrogen (N), phosphorus (P), arsenic (As), antimony (Sb), and bismuth (Bi). The metal element to be a luminescent center is preferably included in the concentration of 0.05 to 5 atom% with respect to the base material. As the metal element, manganese, copper, samarium, terbium, erbium, thulium, europium, cerium, praseodymium, and the like can be given.

Alternatively, in the above structure, plural kinds of the impurity elements are included, which are any one of copper, silver, gold, platinum, and silicon; and any one of fluorine, chlorine, bromine, iodine, boron, aluminum, gallium, indium, and thallium.

Alternatively, in the above structure, plural kinds of the impurity elements are included, which are any one of copper, silver, gold, platinum, and silicon; and any one of lithium, sodium, potassium, rubidium, cesium, nitrogen, phosphorus, arsenic, antimony, and bismuth.

Alternatively, in the above structure, plural kinds of the impurity elements are included, which are any one of copper, silver, gold, platinum, and silicon; any one of fluorine, chlorine, bromine, iodine, boron, aluminum, gallium, indium, and thallium; and any one of lithium, sodium, potassium, rubidium, cesium, nitrogen, phosphorus, arsenic, antimony, and bismuth.

In the above structure, a barrier layer is preferably provided between the light emitting layer and the first electrode. By the barrier layer, carriers can be prevented from passing therethrough, whereby luminous efficiency can be improved. The thickness of the barrier layer is preferably from 1 to 10 nm. The barrier layer is preferably metal oxide or metal nitride. For example, a case where the barrier layer is formed using an oxide of a metal included in the first electrode is preferable because the barrier layer can be formed sequentially after the first electrode is formed.

It is to be noted that the present invention includes in its category a light emitting device having the aforementioned light emitting element. The light emitting device in this specification includes an image display device, a light emitting device, or a light source (including a lighting device). Further, the light emitting device also includes a module in which a connector such as an FPC (Flexible Printed Circuit), a TAB (Tape Automated Bonding) tape, or a TCP (Tape Carrier Package) is attached to a panel where the light emitting element is formed, a module in which a printed wiring board is provided at an end of a TAB tape or a TCP, and a module in which an IC (Integrated Circuit) is directly mounted on the light emitting element by a COG (Chip On Glass) method.

Further, an electronic appliance using the light emitting element of the present invention in its display portion is also included in the category of the present invention. Therefore, the electronic appliance of the present invention has a display portion, and the display portion is equipped with the aforementioned light emitting element and a control means for controlling light emission of the light emitting element.

The light emitting element of the present invention has a layer including a composite material. Since the layer including the composite material is superior in a carrier injecting property and a carrier transporting property, a drive voltage of a light emitting element can be reduced. Further, luminous efficiency can be improved, emission luminance can be improved, and a light emitting element with long lifetime can be obtained.

The light emitting device of the present invention has a light emitting element capable of low-voltage driving. Therefore, power consumption can be reduced. Further, a driver circuit with high withstand voltage is not required, and accordingly, a light emitting device can be manufactured at low cost.

The electronic appliance of the present invention has a light emitting element capable of low-voltage driving. Therefore, power consumption can be reduced. Further, since a driver circuit with high withstand voltage is not required, a manufacturing cost of a light emitting device can be lowered.

### BRIEF DESCRIPTION OF THE DRAWINGS

In the accompanying drawings:
FIGS. 1A and 1B are explanatory views of a light emitting element of the present invention;
FIGS. 2A and 2B are explanatory views of a light emitting element of the present invention;
FIGS. 3A and 3B are explanatory views of a light emitting device of the present invention;
FIGS. 4A to 4D are explanatory views of an electronic appliance of the present invention;
FIG. 5 is an explanatory view of an electronic appliance of the present invention;
FIG. 6 is an explanatory view of a light emitting device of the present invention;
FIG. 7 is an explanatory view of a light emitting device of the present invention;
FIG; 8 is an explanatory view of a light emitting device of the present invention;
FIGS. 9A and 9B are explanatory views of a light emitting device of the present invention;
FIG. 10 is an explanatory view of a light emitting device of the present invention;
FIGS. 11A to 11C are explanatory views of a light emitting device of the present invention;
FIG. 12 is an explanatory view of a light emitting device of the present invention;
FIG. 13 is an explanatory view of a light emitting device of the present invention; and
FIG. 14 is an explanatory view of a light emitting element of the present invention.

### DETAILED DESCRIPTION OF THE INVENTION

Hereinafter, embodiment modes of the present invention will be explained in detail with reference to the accompanied drawings. However, the present invention is not limited to explanation to be given below, and it is to be easily understood that various changes and modifications in modes and details thereof will be apparent to those skilled in the art without departing from the purpose and the scope of the present invention. Therefore, the present invention should not be interpreted as being limited to the description of the embodiment modes to be given below.

### [Embodiment Mode 1]

In this embodiment mode, a composite material used for a light emitting element of the present invention will be explained. It is to be noted that, in this specification, being composite means not only a state in which two materials are simply mixed but also a state in which two materials are mixed at a molecular level and charges are transferred between the materials.

The composite material used in the present invention is a composite material of an organic compound and an inorganic compound. As the organic compound used for the composite material, various compounds such as an aromatic amine compound, a carbazole derivative, aromatic hydrocarbon, and a high molecular compound (oligomer, dendrimer, polymer, or the like) can be used. The organic compound used for the composite material is preferably an organic compound having a high hole transporting property. Specifically, a substance having hole mobility of greater than or equal to 1 × 10⁻⁶ cm²/Vs is preferably used. However, other substances than those may also be used as long as the hole transporting properties thereof are higher than the electron transporting properties thereof. The organic compound that can be used for the composite material is specifically shown below.

For example, the following can be given as the aromatic amine compound: 4,4'-bis[*N*-(1-naphthyl)-*N*-phenylamino]biphenyl (abbreviation: NPB); 4,4'-bis[*N*-(3-methylphenyl)-*N*-phenylamino]biphenyl (abbreviation: TPD); 4,4',4"-tris(*N,N*-diphenylamino)triphenylamine (abbreviation: TDATA); 4,4',4"-tris[*N*-(3-methylphenyl)-*N*-phenylamino]triphenylamine (abbreviation: MTDATA); and the like.

When the following organic compounds are used, a composite material that does not have an absorption peak in a wavelength region of 450 to 800 nm can be obtained.

As aromatic amine contained in a composite material that does not have an absorption peak in a wavelength region of 450 to 800 nm, the following can be given: *N*,*N*'-di(*p*-tolyl)-*N*,*N*'-diphenyl-*p*-phenylenediamine (abbreviation: DTDPPA); 4,4'-bis[*N*-(4-diphenylaminophenyl)-*N*-phenylamino]biphenyl (abbreviation: DPAB); 4,4'-bis(*N*-{4-[N-(3-methylphenyl)-*N*-phenylamino]phenyl}-*N*-phenylamino)biphenyl (abbreviation: DNTPD); 1,3,5-tris[*N*-(4-diphenylaminophenyl)-*N*-phenylamino]benzene (abbreviation: DPA3B); and the like.

As the carbazole derivative that can be used for the composite material that does not have an absorption peak in a wavelength region of 450 to 800 nm, the following can be given: 3-[*N*-(9-phenylcarbazol-3-yl)-*N*-phenylamino]-9-phenylcarbazole (abbreviation: PCzPCA1); 3,6-bis[*N*-(9-phenylcarbazol-3-yl)-*N*-phenylamino]-9-phenylcarbazole (abbreviation: PCzPCA2); *3-*[*N*-(1-naphtyl)-*N*-(9-phenylcarbazol-3-yl)amino]-9-phenylcarbazole (abbreviation: PCzPCN1); and the like.

Moreover, 4,4'-di(*N*-carbazolyl)biphenyl (abbreviation: CBP); 1,3,5-tris[4-(*N*-carbazolyl)phenyl]benzene (abbreviation: TCPB); 9-[4-(*N*-carbazolyl)]phenyl-10-phenylanthracene (abbreviation: CzPA); 2,3,5,6-triphenyl-1,4-bis[4-(*N-*carbazolyl)phenyl]benzene; and the like can also be used.

As the aromatic hydrocarbon that can be used for the composite material that does not have an absorption peak in a wavelength region of 450 to 800 nm, the following is given, for example: 9,10-di(naphthalen-2-yl)-2-*tert*-butylanthracene (abbreviation: t-BuDNA); 9,10-di(naphthalen-1-yl)-2-*tert*-butylanthracene; 9,10-bis(3,5-diphenylphenyl)anthracene (abbreviation: DPPA); 9,10-di(4-phenylphenyl)-2-*tert*-butylanthracene (abbreviation: t-BuDBA); 9,10-di(naphthalen-2-yl)anthracene (abbreviation: DNA); 9,10-diphenylanthracene (abbreviation: DPAnth); 2-*tert*-butylanthracene (abbreviation: t-BuAnth); 9,10-di(4-methylnaphthalen-1-yl)anthracene (abbreviation: DMNA); 2-*tert*-butyl-9,10-bis[2-(naphthalen-1-yl)phenyl]anthracene; 9,10-bis[2-(naphthalen-1-yl)phenyl]anthracene; 2,3,6,7-tetramethyl-9,10-di(naphthalen-1-yl)anthracene; 2,3,6,7-tetramethyl-9,10-di(naphthalen-2-yl)anthracene; 9,9'-bianthryl; 10,10'-diphenyl-9,9'-bianthryl; 10,10'-di(2-phenylphenyl)-9,9'-bianthryl; 10,10'-bis[(2,3,4,5,6-pentaphenyl)phenyl]-9,9'-bianthryl; anthracene; tetracene; rubrene; perylene; 2,5,8,11-tetra(*tert*-butyl)perylene; and the like. Besides, pentacene, coronene, or the like can also be used. It is more preferable to use such aromatic hydrocarbon that has hole mobility of greater than or equal to 1 × 10⁻⁶ cm²/Vs and that has 14 to 42 carbon atoms, in such a manner.

Aromatic hydrocarbon that can be used for the composite material that does not have an absorption peak in a wavelength region of 450 to 800 nm may have a vinyl skeleton. As aromatic hydrocarbon having a vinyl group, the following is given, for example: 4,4'-bis(2,2-diphenylvinyl)biphenyl (abbreviation: DPVBi); 9,10-bis[4-(2,2-diphenylvinyl)phenyl]anthracene (abbreviation: DPVPA); and the like.

Moreover, a high molecular compound such as poly(N-vinylcarbazole) (abbreviation: PVK) and poly(4-vinyltriphenylamine) (abbreviation: PVTPA) can also be used.

As the inorganic compound used for the composite material, transition metal oxide is preferably used. Moreover, an oxide of a metal belonging to Groups 4 to 8 in the periodic table is preferably used. Specifically, it is preferable to use vanadium oxide, niobium oxide, tantalum oxide, chromium oxide, molybdenum oxide, tungsten oxide, manganese oxide, and rhenium oxide because of their high electron accepting properties. Above all, molybdenum oxide is particularly preferable since it is stable in the air, has a low moisture absorption property, and is easily treated.

The composite material described in this embodiment mode is superior in a hole injecting property and a hole transporting property, and has high conductivity, so that carriers can be easily injected from an electrode and can be efficiently transported to a light emitting layer.

The composite material can have an ohmic contact with an electrode. Therefore, a material for the electrode can be selected without considering the work function.

By selection of the kind of the organic compound contained in the composite material, a composite material that does not have an absorption peak in a wavelength region of 450 to 800 nm can be obtained. Therefore, light emitted from a light emitting region is efficiently transmitted through the composite material without being absorbed. Thus, external light extraction efficiency can be improved.

Since the layer including the composite material of an organic compound and an inorganic compound has high conductivity, increase in drive voltage can be suppressed even when the layer including the composite material is thickly formed. Therefore, it becomes possible to optimize the film thickness of the layer including the composite material so that external light extraction efficiency increases while suppressing the increase in drive voltage. In addition, improvement in color purity by optical design can be achieved without increase in the drive voltage.

A method for manufacturing the layer including the composite material may be any method, regardless of a wet method or a dry method. For example, the layer including the composite material can be manufactured by co-evaporation of the aforementioned organic compound and inorganic compound. Since molybdenum oxide is easily vaporized in vacuum, it is also preferable from the aspect of a manufacturing process. Further, the layer including the composite material can also be obtained in such a way that a solution including the aforementioned organic compound and metal alkoxide is applied and baked.

### [Embodiment Mode 2]

In this embodiment mode, a light emitting material used for a light emitting element of the present invention and a forming method thereof will be explained. As the light emitting material used in the present invention, a material formed using a base material (also called as a matrix material) and at least one kind of an impurity element to be a luminescent center can be given. The impurity element includes no element which forms a base material.

As the base material used for the light emitting material, sulfide, oxide, and nitride can be used. That is, a compound including an element belonging to Group 2 and an element belonging to Group 16, or a compound including an element belonging to Group 12 and an element belonging to Group 16, in the periodic table, can be used. Alternatively, a compound including an element belonging to Group 3 and an element belonging to Group 16, or a compound including an element belonging to Group 13 and an element belonging to Group 16, in the periodic table, can be used. Further alternatively, a compound including an element belonging to Group 3 and an element belonging to Group 15, or a compound including an element belonging to Group 13 and an element belonging to Group 15, in the periodic table, can be used. As sulfide, for example, zinc sulfide (ZnS), cadmium sulfide (CdS), calcium sulfide (CaS), yttrium sulfide (Y₂S₃), gallium sulfide (Ga₂S₃), strontium sulfide (SrS), barium sulfide (BaS), or the like can be used. As oxide, for example, zinc oxide (ZnO), yttrium oxide (Y₂O₃), or the like can be used. In addition, as nitride, for example, aluminum nitride (AlN), gallium nitride (GaN), indium nitride (InN), or the like can be used. In addition, for example, zinc selenide (ZnSe), zinc telluride (ZnTe), or the like can also be used, and a ternary system mixed crystal such as calcium-gallium sulfide (CaGa₂S₄), strontium-gallium sulfide (SrGa₂S₄), or barium-gallium sulfide (BaGa₂S₄) may also be used.

As a luminescent center utilizing inner shell electronic transition of a metal ion, manganese (Mn), copper (Cu), samarium (Sm), terbium (Tb), erbium (Er), thulium (Tm), europium (Eu), cerium (Ce), praseodymium (Pr), or the like can be used. As charge compensation, a halogen element such as fluorine (F) or clorine (Cl) may be added.

As a luminescent center utilizing a donor-acceptor recombination, a light emitting material including a first impurity element and a second impurity element can be used.

As the first impurity element, for example, copper (Cu), silver (Ag), gold (Au), platinum (Pt), silicon (Si), or the like can be used.

As the second impurity element, for example, fluorine (F), chlorine (Cl), bromine (Br), iodine (I), boron (B), aluminum (Al), gallium (Ga), indium (In), thallium (T1), or the like can be used.

As a light emitting material relating to the present invention, an impurity element is made to be included in a base material by solid phase reaction, that is, by a method in which a base material and an impurity element are weighed, mixed in a mortar, and heated in an electric furnace to be reacted with each other. For example, after the base material, the first impurity element or a compound including the first impurity element, and the second impurity element or a compound including the second impurity element are each weighed and mixed in a mortar, heating and baking are performed in an electric furnace. The baking temperatures are preferably 700 to 1500°C. This is because solid phase reaction does not proceed in a case where the temperature is too low, or the base material is decomposed in a case where the temperature is too high. Although the baking may be performed to the material in a powder state, the baking is preferably performed to the material in a pellet state.

As the impurity element in a case of utilizing solid phase reaction, a compound including the first impurity element and the second impurity element may be combined. In this case, an impurity element is easily diffused and solid phase reaction easily proceeds. Thus, a uniform light emitting material can be obtained. Further, since an additional impurity element does not enter, a light emitting material with high purity can be obtained. As the compound including the first impurity element and the second impurity element, for example, copper fluoride (CuF₂), copper chloride (CuCI), copper iodide (CuI), copper bromide (CuBr), copper nitride (Cu₃N), copper phosphide (Cu₃P), silver fluoride (AgF), silver chloride (AgCl), silver iodide (Agl), silver bromide (AgBr), gold chloride (AuCl₃), gold bromide (AuBr₃), platinum chloride (PtCl₂), or the like can be used.

Alternatively, a light emitting material including a third impurity element instead of the second impurity element may be used.

As the third impurity element, for example, lithium (Li), sodium (Na), potassium (K), rubidium (Rb), cesium (Cs), nitrogen (N), phosphorus (P), arsenic (As), antimony (Sb), bismuth (Bi), or the like can be used.

The concentration of these impurity elements may be from 0.01 to 10 mol% with respect to the base material, and preferably, the concentration is from 0.1 to 5 mol%.

As a light emitting material having high electric conductivity, a light emitting material using the material described above as the base material and including the first impurity element, the second impurity element, and the third impurity element described above, can be used. The concentration of these impurity elements may be from 0.01 to 10 mol% with respect to the base material, and preferably, the concentration is from 0.1 to 5 mol%.

As the compound formed using the second impurity element and the third impurity element, for example, alkali halide such as lithium fluoride (LiF), lithium chloride (LiCl), lithium iodide (LiI), lithium bromide (LiBr), or sodium chloride (NaCl); boron nitride (BN); aluminum nitride (AlN); aluminium antimonide (AlSb); gallium phosphide (GaP); gallium arsenide (GaAs); indium phosphide (InP); indium arsenide (InAs); indium antimonide (InSb); or the like can be used.

A light emitting layer using a light emitting material using the material described above as the base material and including the first impurity element, the second impurity element, and the third impurity element described above, can emit light without requiring a hot electron accelerated by a high electric field. That is, a high voltage is not required to be applied to a light emitting element, and accordingly, a light emitting element which can be operated at a low drive voltage can be obtained. Further, since light can be emitted at a low drive voltage, a light emitting element in which power consumption is also reduced can be obtained. In addition, an element to be another luminescent center may be further included.

Alternatively, a light emitting material using the material described above as the base material and including the second impurity element, the third impurity element, and the luminescent center utilizing inner shell electronic transition of a metal ion described above, can be used. In this case, the metal ion to be a luminescent center is preferably from 0.05 to 5 atom% with respect to the base material. The concentration of the second impurity element is preferably from 0.05 to 5 atom% with respect to the base material, and the concentration of the third impurity element is preferably from 0.05 to 5 atom% with respect to the base material. The light emitting material having such a structure can emit light at a low voltage, and thus, a light emitting element which can emit light at a low drive voltage can be obtained. Accordingly, a light emitting element in which power consumption is reduced can be obtained. In addition, an element to be another luminescent center may be further included.

For example, a light emitting material including ZnS as the base material, Cu as the first impurity element, Cl and Ga as the second impurity element, As as the third impurity element, and Mn as another luminescent center, can also be used. Such a light emitting material can be formed by the following method. Mn is added to a light emitter (ZnS:Cu,Cl) in which copper sulfate (CuS), sulfur, and zinc oxide (ZnO) are combined with ZnS, and baking is performed for approximately 2 to 4 hours in vacuum. The baking temperatures are preferably from 700 to 1500°C. The baked object is crushed to have a grain diameter of 5 to 20 µm, and GaAs having a grain diameter of 1 to 3 µm is added therein and stirred. The mixture is baked at approximately 500 to 800°C for 2 to 4 hours in a nitrogen airflow including a sulfur gas, whereby a light emitting material can be obtained. By the formation of the thin film by an evaporation method or the like using this light emitting material, the light emitting material can be used as a light emitting layer of a light emitting element.

By further addition of an impurity element with respect to the light emitting material described above, a crystal system of the light emitting material can be controlled. As an impurity capable of controlling a crystal system, GaP, GaAs, GaSb, InP, InAs, InSb, Si, Ge, and the like can be given as an impurity by which a cubic system can be obtained. Further, GaN and InN can be given as an impurity by which a hexagonal system can be obtained. Besides, AlP, AIN, AlSb, and the like can be given. By the control of a crystal system of a light emitting material, luminous efficiency can be improved.

### [Embodiment Mode 3]

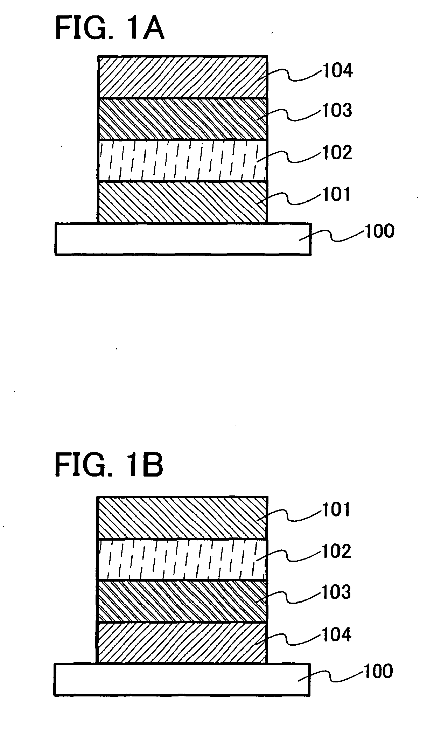

In this embodiment mode, one mode of a light emitting element of the present invention will be explained with reference to FIGS. 1A and 1B. In this specification, an EL layer indicates a layer provided between a first electrode and a second electrode.

A light emitting element to be described in this embodiment mode has an element structure having, over a substrate 100, a first electrode 101 and a second electrode 104, a layer 103 including a composite material to be in contact with the second electrode 104, and a light emitting layer 102 between the first electrode 101 and the layer 103 including the composite material. In the light emitting element to be described in this embodiment mode, light emission is obtained by application of a voltage between the first electrode 101 and the second electrode 104. In this embodiment mode, a case will be explained, in which light emission is obtained when an electric potential of the second electrode is higher than an electric potential of the first electrode.

The substrate 100 is used as a support of the light emitting element. The substrate 100 can be formed using, for example, glass, plastic, or the like. Other materials can also be used as long as the substrate 100 can serve as the support of the light emitting element in a manufacturing process of the light emitting element.

The first electrode 101 can be formed using various metals, alloys, conductive compounds, mixtures of these, or the like. Specifically, for example, indium oxide-tin oxide (ITO: Indium Tin Oxide), indium oxide-tin oxide containing silicon or silicon oxide, indium oxide-zinc oxide (IZO: Indium Zinc Oxide), indium oxide-tin oxide containing tungsten oxide and zinc oxide (IWZO), or the like is given. These conductive metal oxide films are generally formed by a sputtering method. For example, indium oxide-zinc oxide (IZO) can be formed by a sputtering method using a target in which 1 to 20 wt% of zinc oxide is added to indium oxide. Indium oxide-tin oxide containing tungsten oxide and zinc oxide (IWZO) can be formed by a sputtering method using a target in which 0.5 to 5 wt% of tungsten oxide and 0.1 to 1 wt% of zinc oxide are contained with respect to indium oxide. Further, aluminum (Al), silver (Ag), gold (Au), platinum (Pt), nickel (Ni), tungsten (W), chromium (Cr), molybdenum (Mo), iron (Fe), cobalt (Co), copper (Cu), palladium (Pd), titanium (Ti), titanium nitride (TiN), or the like can also be used. In a case where the first electrode 101 or the second electrode 104 is formed to be an electrode having a light transmitting property, even when a material with low transmissivity of visible light is used, the electrode can be used as a light transmissive electrode by formation of the material to have a thickness of approximately 1 to 50 nm, preferably, approximately 5 to 20 nm. Alternatively, the electrode can be manufactured using a vacuum evaporation method, a CVD method, or a sol-gel method as well as a sputtering method.

The light emitting layer 102 is a layer including the light emitting material described in Embodiment Mode 2 and can be formed using various methods. Although the thickness is not limited in particular, the thickness is preferably from 10 to 100 nm.

The composite material described in Embodiment Mode 1 can be used for the layer 103 including the composite material. In a case where the light emitting layer 102 and the layer 103 including the composite material are formed using an evaporation method, the light emitting layer 102 and the layer 103 including the composite material can be continuously formed in vacuum. Therefore, preferably, contamination at an interface between layers can be prevented.

The second electrode 104 can be formed using various metals, alloys, conductive compounds, mixtures of these, or the like. Specifically, for example, indium oxide-tin oxide (ITO: Indium Tin Oxide), indium oxide-tin oxide containing silicon or silicon oxide, indium oxide-zinc oxide (IZO: Indium Zinc Oxide), indium oxide-tin oxide containing tungsten oxide and zinc oxide (IWZO), or the like is given. These conductive metal oxide films are generally formed by a sputtering method. For example, indium oxide-zinc oxide (IZO) can be formed by a sputtering method using a target in which 1 to 20 wt% of zinc oxide is added to indium oxide. Indium oxide-tin oxide containing tungsten oxide and zinc oxide (IWZO) can be formed by a sputtering method using a target in which 0.5 to 5 wt% of tungsten oxide and 0.1 to 1 wt% of zinc oxide are contained with respect to indium oxide. Further, aluminum (Al), silver (Ag), gold (Au), platinum (Pt), nickel (Ni), tungsten (W), chromium (Cr), molybdenum (Mo), iron (Fe), cobalt (Co), copper (Cu), palladium (Pd), titanium (Ti), titanium nitride (TiN), or the like can also be used. In a case where the first electrode 101 or the second electrode 104 is formed to be an electrode having a light transmitting property, even when a material with low transmissivity of visible light is used, the electrode can be used as a light transmissive electrode by formation of the material to have a thickness of approximately 1 to 50 nm, preferably, approximately 5 to 20 nm. Alternatively, the electrode can be manufactured using a vacuum evaporation method, a CVD method, or a sol-gel method as well as a sputtering method.

However, since light emission is extracted to outside through the first electrode 101 or the second electrode 104, it is necessary that at least one of the first electrode 101 and the second electrode 104 is an electrode having a light transmitting property.

Although not shown, a buffer layer may be provided between the light emitting layer and the layer including the composite material, or between the light emitting layer and the electrode. The buffer layer has a role to facilitate injection of carriers or a role to suppress mixture of both layers. Although the buffer layer is not limited in particular, for example, the following can be used: ZnS, ZnSe, ZnTe, CdS, SrS, BaS, or the like, which is a base material of the light emitting layer; CuS or Cu₂S; or LiF, CaF₂, BaF₂, MgF₂, or the like, which is alkali halide.

FIG. 1A shows a structure where the first electrode 101 is provided on the substrate 100 side. However, a structure may also be employed, in which layers are stacked in the order that is reverse to that of FIG. 1A and the second electrode 104 is provided on the substrate 100 side as shown in FIG. 1B.

The light emitting element of the present invention has the layer including the composite material. The layer including the composite material is superior in a carrier injecting property and a carrier transporting property, and accordingly, a drive voltage of the light emitting element can be reduced. Further, luminous efficiency can be improved.

Many base materials of the light emitting material show a property as an n-type semiconductor. Therefore, with the use of a composite material serving as a p-type semiconductor, a carrier injecting property is improved. Further, luminous efficiency is improved. Furthermore, light emission due to electrons and holes can be obtained.

This embodiment mode can be appropriately combined with another embodiment mode.

### [Embodiment Mode 4]

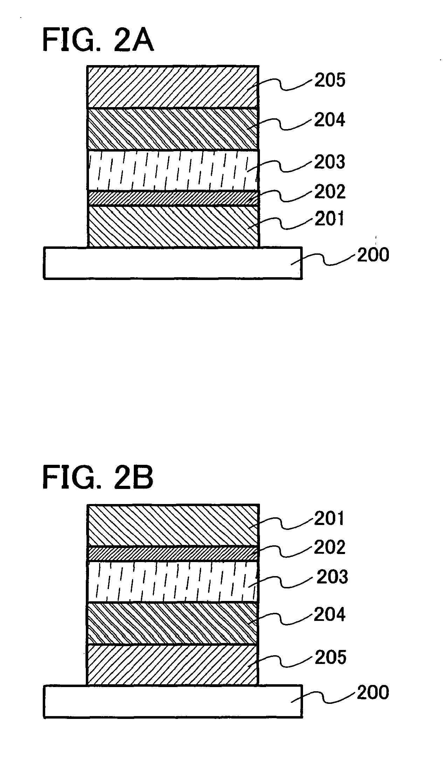

In this embodiment mode, one mode of a light emitting element of the present invention, which is different from that of Embodiment Mode 3, will be explained with reference to FIGS. 2A and 2B.

A light emitting element to be described in this embodiment mode has an element structure having, over a substrate 200, a first electrode 201 and a second electrode 205, a layer 204 including a composite material to be in contact with the second electrode 205, and a light emitting layer 203 and a barrier layer 202 between the first electrode 201 and the layer 204 including the composite material. In the light emitting element to be described in this embodiment mode, light emission is obtained by application of a voltage between the first electrode 201 and the second electrode 205. In this embodiment mode, a case will be explained, in which light emission is obtained when an electric potential of the second electrode is higher than an electric potential of the first electrode.

The substrate 200 is used as a support of the light emitting element. The substrate 200 can be formed using, for example, glass, plastic, or the like. Other materials can also be used as long as the substrate 200 can serve as the support of the light emitting element in a manufacturing process of the light emitting element.

The first electrode 201 can be formed using various metals, alloys, conductive compounds, mixtures of these, or the like. Specifically, for example, indium oxide-tin oxide (ITO: Indium Tin Oxide), indium oxide-tin oxide containing silicon or silicon oxide, indium oxide-zinc oxide (IZO: Indium Zinc Oxide), indium oxide-tin oxide containing tungsten oxide and zinc oxide (IWZO), or the like is given. These conductive metal oxide films are generally formed by a sputtering method. For example, indium oxide-zinc oxide (IZO) can be formed by a sputtering method using a target in which 1 to 20 wt% of zinc oxide is added to indium oxide. Indium oxide-tin oxide containing tungsten oxide and zinc oxide (IWZO) can be formed by a sputtering method using a target in which 0.5 to 5 wt% of tungsten oxide and 0.1 to 1 wt% of zinc oxide are contained with respect to indium oxide. Further, aluminum (Al), silver (Ag), gold (Au), platinum (Pt), nickel (Ni), tungsten (W), chromium (Cr), molybdenum (Mo), iron (Fe), cobalt (Co), copper (Cu), palladium (Pd), titanium (Ti), titanium nitride (TiN), or the like can also be used. In a case where the first electrode 201 or the second electrode 205 is formed to be an electrode having a light transmitting property, even when a material with low transmissivity of visible light is used, the electrode can be used as a light transmissive electrode by formation of the material to have a thickness of approximately 1 to 50 nm, preferably, approximately 5 to 20 nm. Alternatively, the electrode can be manufactured using a vacuum evaporation method, a CVD method, or a sol-gel method as well as a sputtering method.

The barrier layer 202 is a thin film of an insulating substance, and can be formed using insulating metal oxide or nitride. For example, an oxide or a nitride of aluminum (Al), tungsten (W), chromium (Cr), molybdenum (Mo), titanium (Ti), or the like can be used.

In a case where the barrier layer 202 is formed after forming the first electrode 201, the first electrode 201 is formed using a material which can be anodized, and the surface of the first electrode 201 is anodized, whereby the barrier layer 202 can be formed. For example, in a case where Al is used for the first electrode and the surface of the first electrode is anodized, aluminum oxide (AlₓO_{y}) can be formed as the barrier layer. Alternatively, in a case where Ti is used for the first electrode and the surface of the first electrode is anodized, titanium oxide (TiOₓ) can be formed as the barrier layer. In the case where the barrier layer is formed by anodization, a barrier layer of which film quality is changed (a dense anodized film, a porous anodized film, or the like) can be formed in accordance with an anodization condition. Further, the thickness of the barrier layer can be controlled.

For example, as an electrolysis solution, a solution where an ethylene glycol solution of 3% tartaric acid is neutralized with aqueous ammonia and the acidity is adjusted to pH=6.92, is used. In the electrolysis solution, current flows between a cathode and an anode with platinum as the cathode, and aluminum, which is the first electrode, as the anode, under conditions of a formation current of 5 to 6 mA and a reach voltage of 40 to 100 V Accordingly, an anodized film with dense and firm film quality can be formed over the surface of the aluminum film. The thickness of this anodized film can be roughly controlled by an applied voltage.

Further, the barrier layer 202 can be formed using a sputtering method, a sol-gel method, or the like as well as the anodization described above.

The thickness of the barrier layer 202 is preferably 1 to 10 nm to suppress increase in drive voltage. By the barrier layer 202, it enables to prevent that carriers injected to the light emitting layer pass through the light emitting layer without contributing light emission and enter the electrode. Accordingly, luminous efficiency can be improved.

The light emitting layer 203 is a layer including the light emitting material described in Embodiment Mode 2, and can be formed using various methods. Although the thickness is not limited in particular, the thickness is preferably from 10 to 100 nm.

The composite material described in Embodiment Mode 1 can be used for the layer 204 including a composite material. In a case where the light emitting layer 203 and the layer 204 including the composite material are formed using an evaporation method, the light emitting layer 203 and the layer 204 including the composite material can be continuously formed in vacuum. Therefore, preferably, contamination at an interface between layers can be prevented.

The second electrode 205 can be formed using various metals, alloys, conductive compounds, mixtures of these, or the like. Specifically, for example, indium oxide-tin oxide (ITO: Indium Tin Oxide), indium oxide-tin oxide containing silicon or silicon oxide, indium oxide-zinc oxide (IZO: Indium Zinc Oxide), indium oxide-tin oxide containing tungsten oxide and zinc oxide (IWZO), or the like are given. These conductive metal oxide films are generally formed by a sputtering method. For example, indium oxide-zinc oxide (IZO) can be formed by a sputtering method using a target in which 1 to 20 wt% of zinc oxide is added to indium oxide. Indium oxide-tin oxide containing tungsten oxide and zinc oxide (IWZO) can be formed by a sputtering method using a target in which 0.5 to 5 wt% of tungsten oxide and 0.1 to 1 wt% of zinc oxide are contained with respect to indium oxide. Further, aluminum (Al), silver (Ag), gold (Au), platinum (Pt), nickel (Ni), tungsten (W), chromium (Cr), molybdenum (Mo), iron (Fe), cobalt (Co), copper (Cu), palladium (Pd), titanium (Ti), titanium nitride (TiN), or the like can also be used. In a case where the first electrode 201 or the second electrode 205 is formed to be an electrode having a light transmitting property, even when a material with low transmissivity of visible light is used, the electrode can be used as a light transmissive electrode by forming the material to have a thickness of approximately 1 to 50 nm, preferably, approximately 5 to 20 nm. Alternatively, the electrode can be manufactured using a vacuum evaporation method, a CVD method, or a sol-gel method as well as a sputtering method.

However, since light emission is extracted to outside through the first electrode 201 or the second electrode 205, it is necessary that at least one of the first electrode 201 and the second electrode 205 is an electrode having a light transmitting property.

FIG. 2A shows a structure where the first electrode 201 is provided on the substrate 200 side. However, a structure may also be employed, in which layers are stacked in the order that is reverse to that of FIG. 2A and the second electrode 205 is provided on the substrate 200 side as shown in FIG. 2B. In a case of the structure shown in FIG. 2B, the barrier layer 202 is preferably formed using a sputtering method or a sol-gel method.

The light emitting element of the present invention has the layer including the composite material. The layer including the composite material is superior in a carrier injecting property and a carrier transporting property, and accordingly, a drive voltage of the light emitting element can be reduced. Further, luminous efficiency can be improved.

Many base materials of the light emitting material show a property as an n-type semiconductor. Therefore, with the use of a composite material serving as a p-type semiconductor, a carrier injecting property is improved. Further, luminous efficiency is improved. Furthermore, light emission due to electrons and holes can be obtained.

The light emitting element described in the embodiment mode has the barrier layer which is a thin film of an insulating substance. By the barrier layer, it enables to prevent that carriers injected to the light emitting layer pass through the light emitting layer without contributing light emission and enter the electrode. Accordingly, luminous efficiency can be improved.

This embodiment mode can be appropriately combined with another embodiment mode.

### [Embodiment Mode 5]

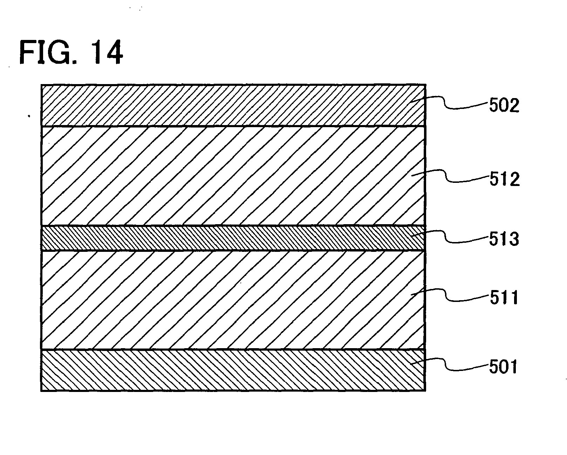

In this embodiment mode, a mode of a light emitting element having a structure in which a plurality of light emitting units relating to the present invention is stacked (hereinafter, referred to as a stack type element), will be explained with reference to FIG. 14. This light emitting element is a light emitting element having a plurality of light emitting units between a first electrode and a second electrode.

In FIG. 14, a first light emitting unit 511 and a second light emitting unit 512 are stacked between a first electrode 501 and a second electrode 502. As the first electrode 501 and the second electrode 502, an electrode similar to that described in Embodiment Modes 3 and 4 can be applied. The first light emitting unit 511 and the second light emitting unit 512 have the same structure, and as the structure, a structure similar to that described in Embodiment Modes 3 and 4 can be applied. In other words, the first light emitting unit 511 and the second light emitting unit 512 each have a structure in which a light emitting layer and a layer including a composite material are stacked. Further, similarly to Embodiment Mode 4, a structure can also be applied, in which a barrier layer, a light emitting layer, and a layer including a composite material are stacked.

A charge generation layer 513 includes a composite of an organic compound and metal oxide. The composite of an organic compound and metal oxide is formed using an organic compound and metal oxide such as V₂O₅, MoO₃, or WO₃. As the organic compound, various compounds such as an aromatic amine compound, a carbazole derivative, aromatic hydrocarbon, and a high molecular compound (oligomer, dendrimer, polymer, or the like) can be used. An object having hole mobility of greater than or equal to 1 × 10⁻⁶ cm²/Vs as a hole transporting organic compound is preferably applied to the organic compound. However, other substances than those may also be used as long as the hole transporting properties thereof are higher than the electron transporting properties thereof. The composite of an organic compound and metal oxide is superior in a carrier injecting property and a carrier transporting property, and accordingly, low-voltage driving and low-current driving can be realized.

It is to be noted that the charge generation layer 513 may be formed with a combination of the composite of an organic compound and metal oxide and other materials. For example, the charge generation layer 513 may be formed with a combination of a layer including the composite of an organic compound and metal oxide and a layer including one compound selected from electron donating substances and a compound having a high electron transporting property. Further, the charge generation layer 513 may be formed with a combination of a layer including the composite of an organic compound and metal oxide and a transparent conductive film.

In any cases, the charge generation layer 513 interposed between the first light emitting unit 511 and the second light emitting unit 512 is acceptable as long as electrons are injected to a light emitting unit on one side and holes are injected to a light emitting unit on the other side when a voltage is applied to the first electrode 501 and the second electrode 502.

In this embodiment mode, the light emitting element having two light emitting units is explained; however, similarly, the present invention can be applied to a light emitting element in which three or more light emitting units are stacked. Like the light emitting element relating to this embodiment mode, a plurality of light emitting units is disposed between a pair of electrodes so as to be partitioned with an electrically-insulating charge generation layer, and accordingly, an element with long lifetime in a high luminance region can be realized while current density is kept to be low. In a case where the light emitting element is applied to lighting as an application example, voltage drop due to resistance of an electrode material can be reduced. Accordingly, light can be uniformly emitted with a large area. In a case where the light emitting element is applied to a display device, a high-contrast display device capable of low-voltage driving and consuming low power, can be realized.

This embodiment mode can be appropriately combined with another embodiment mode.

### [Embodiment Mode 6]

In this embodiment mode, a light emitting device having a light emitting element manufactured by applying the present invention will be explained.

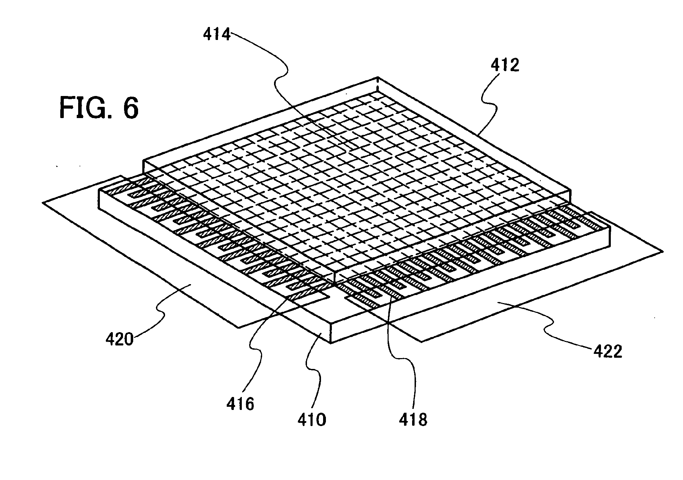

In this embodiment mode, as one mode of the light emitting device, a display device will be explained with reference to FIGS. 6 to 8, FIGS. 9A and 9B, and FIG. 10. FIG. 6 is a schematic structural view showing a main part of a display device.

A substrate 410 is provided with a first electrode 416 and a second electrode 418 which is extended in a direction intersecting with the first electrode 416. At least, an intersecting portion of the first electrode 416 and the second electrode 418 is provided with an EL layer similar to that described in Embodiment Modes 3 to 5, which forms a light emitting element. In the display device of FIG. 6, a plurality of first electrodes 416 and a plurality of second electrodes 418 are disposed, and light emitting elements to be pixels are arranged in a matrix, thereby forming a display portion 414. In this display portion 414, an external circuit controls electric potentials of the first electrode 416 and the second electrode 418 to control light emission/non-light emission of each light emitting element, whereby a moving image and a still image can be displayed.

In this display device, light emission/non-light emission of the light emitting element is selected by application of a signal for displaying an image to each of the first electrode 416, which is provided to be extended in one direction of the substrate 410, and the second electrode 418, which intersects therewith. In other words, the display device is a simple matrix display device in which a pixel is mainly driven with a signal given from the external circuit. Such a display device has a simple structure; therefore, the display device can be easily manufactured even when the display device is formed to have a large area.

An opposing substrate 412 may be provided according to need, and the opposing substrate 412 can serve as a protective member by being provided in accordance with a position of the display portion 414. It is not necessary that the opposing substrate 412 is formed using a hard plate member, and a resin film or a resin material to be applied can be substituted therefor. The first electrode 416 and the second electrode 418 are led to an edge portion of the substrate 410, thereby forming a terminal to be connected to the external circuit. In other words, the first electrode 416 and the second electrode 418 are electrically connected to flexible wiring boards 420 and 422, respectively, in the edge portion of the substrate 410. As the external circuit, a controller circuit for controlling an image signal, a power supply circuit, a tuner circuit, and the like are included.

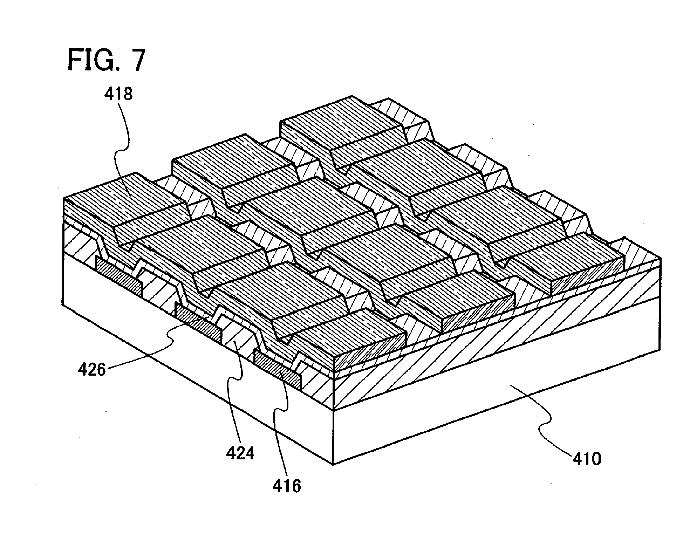

FIG. 7 is a partially-enlarged view showing a structure of the display portion 414. A partition layer 424 is formed in a side edge portion of the first electrode 416 formed over the substrate 410. An EL layer 426 is formed at least over an exposed surface of the first electrode 416. The second electrode 418 is provided over the EL layer 426. The second electrode 418 intersects with the first electrode 416; therefore, the second electrode 418 is provided to be extended over the partition layer 424. The partition layer 424 is formed using an insulating material so as to prevent short-circuit between the first electrode 416 and the second electrode 418. In a portion of the partition layer 424 covering an edge portion of the first electrode 416, a side edge portion of the partition layer 424 is inclined so as to prevent steep level difference, which is a so-called tapered shape. With the partition layer 424 having such a shape, coverage of the EL layer 426 and the second electrode 418 is improved, resulting in eliminating defects such as cracking or fracture.

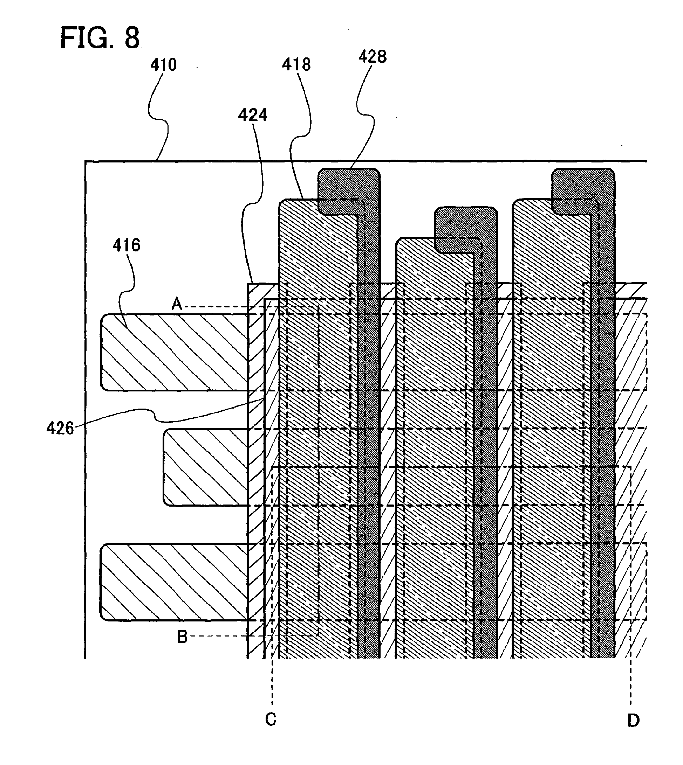

FIG. 8 is a plan view of the display portion 414, which shows disposition of the substrate 410, the first electrode 416, the second electrode 418, the partition layer 424, and the EL layer 426. An auxiliary electrode 428 is preferably provided in order to reduce resistance loss in a case where the second electrode 418 is formed using a transparent conductive film of oxide such as indium tin oxide, zinc oxide, or the like. In this case, the auxiliary electrode 428 may be formed using a high melting point metal such as titanium, tungsten, chromium, or tantalum or with the combination of high melting point metal and low resistance metal such as aluminum or silver.

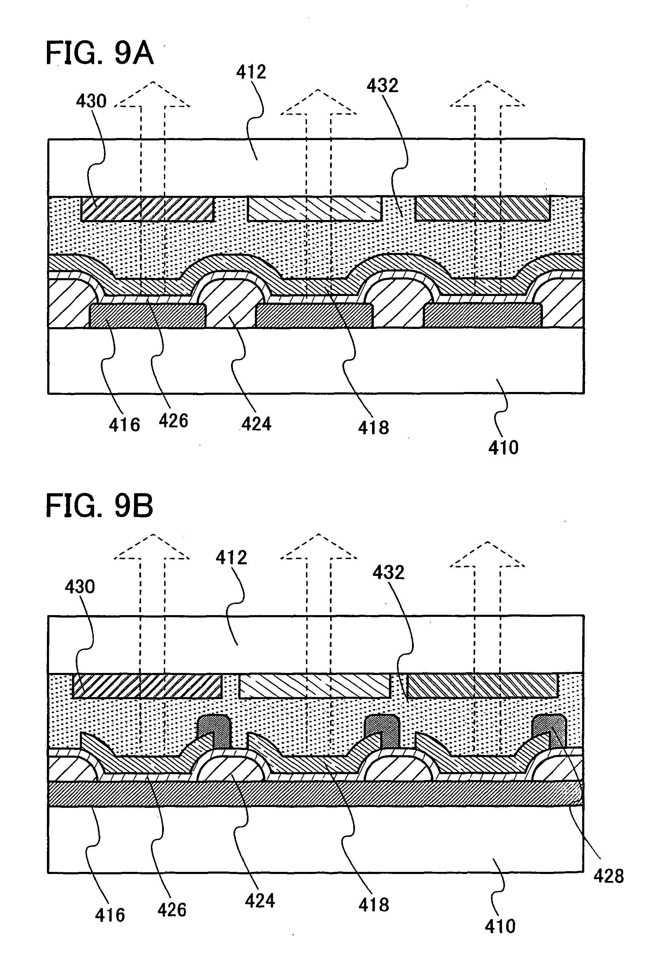

FIGS. 9A and 9B are cross-sectional views taken along lines A-B and C-D, respectively, in FIG. 8. FIG. 9A is a cross-sectional view in which the first electrodes 416 are arranged, and FIG. 9B is a cross-sectional view in which the second electrodes 418 are arranged. The EL layer 426 is formed at an intersecting portion of the first electrode 416 and the second electrode 418, and a light emitting element is formed at a portion thereof. The auxiliary electrode 428 shown in FIG. 9B is over the partition layer 424, and provided to be in contact with the second electrode 418. The auxiliary electrode 428 is provided over the partition layer 424, whereby the light emitting element formed at the intersection portion of the first electrode 416 and the second electrode 418 is not light-shielded. Accordingly, emitted light can be effectively utilized, and further, short-circuit between the auxiliary electrode 428 and the first electrode 416 can be prevented.

FIGS. 9A and 9B show one example in which a color conversion layer 430 is provided on the opposing substrate 412. The color conversion layer 430 serves to make a difference in emission color by wavelength conversion of light emitted from the EL layer 426. In this case, light emitted from the EL layer 426 is preferably blue light or ultraviolet light with high energy. In a case where color conversion layers serving to convert light into red light, green light, and blue light are arranged as the color conversion layer 430, a display device performing RGB color display can be obtained. Alternatively, the color conversion layer 430 can be replaced with a colored layer (color filter). In that case, the EL layer 426 may have a structure so as to emit white light. A filler 432 serves to fix the opposing substrate 412 to the substrate 410, and may be appropriately provided.

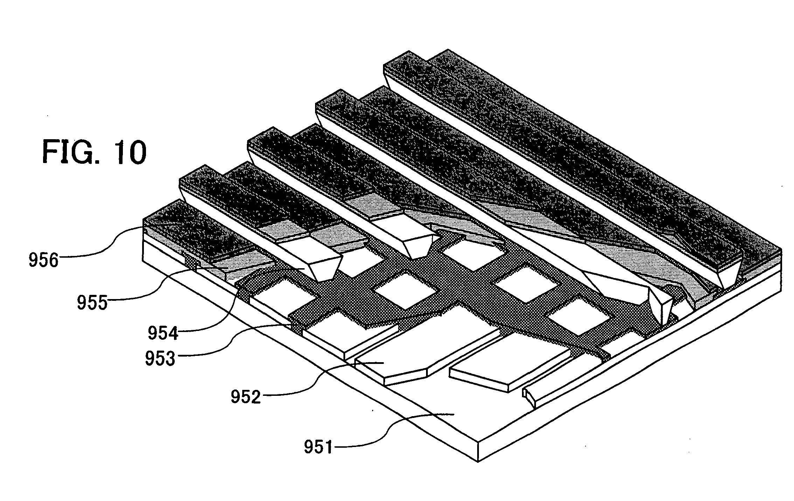

FIG. 10 shows another structure of the display portion 414. In the structure of FIG. 10, an edge portion of the first electrode 952 is covered with an insulating layer 953. A partition layer 954 is provided over the insulating layer 953. A side wall of the partition layer 954 slopes so that a distance between one side wall and the other side wall becomes narrow toward a substrate surface. In other words, a cross section of the partition layer 954 in the direction of a narrow side is trapezoidal, and a base (a side in the same direction as a plane direction of the insulating layer 953 and in contact with the insulating layer 953) is shorter than an upper side (a side in the same direction as the plane direction of the insulating layer 953 and not in contact with the insulating layer 953). The partition layer 954 is provided in this manner, whereby an EL layer 955 and a second electrode 956 can be formed in a self-aligned manner using the partition layer 954.

In the above description, in a case where aluminum, titanium, tantalum, or the like is used as the first electrode 416 and indium oxide, indium oxide-tin oxide (ITO), indium oxide zinc oxide, or zinc oxide is used as the second electrode 418, a display device in which the display portion 414 is formed on the opposing substrate 412 side can be obtained. In this case, by the formation of a thin oxide film over the surface of the first electrode 416, a barrier layer is formed, by which luminous efficiency can be increased due to a carrier blocking effect. In a case where indium oxide, indium oxide-tin oxide (ITO), indium oxide zinc oxide, or zinc oxide is used as the first electrode 416 and aluminum, titanium, tantalum, or the like is used as the second electrode 418, a display device in which the display portion 414 is formed on the substrate 410 side can be obtained. Further, when both of the first electrode 416 and the second electrode 418 are formed using a transparent electrode, a display device which performs double-sided display can be obtained.

In the display device of this embodiment mode, the light emitting element emits light at a low voltage; therefore, a boosting circuit or the like is not required, and the structure of the device can be simplified. Further, the EL layer in the light emitting element is not required to be thickened, and accordingly, a display device having a thinner shape can be realized.

### [Embodiment Mode 7]

In this embodiment mode, a light emitting device having a light emitting element manufactured by applying the present invention will be explained.

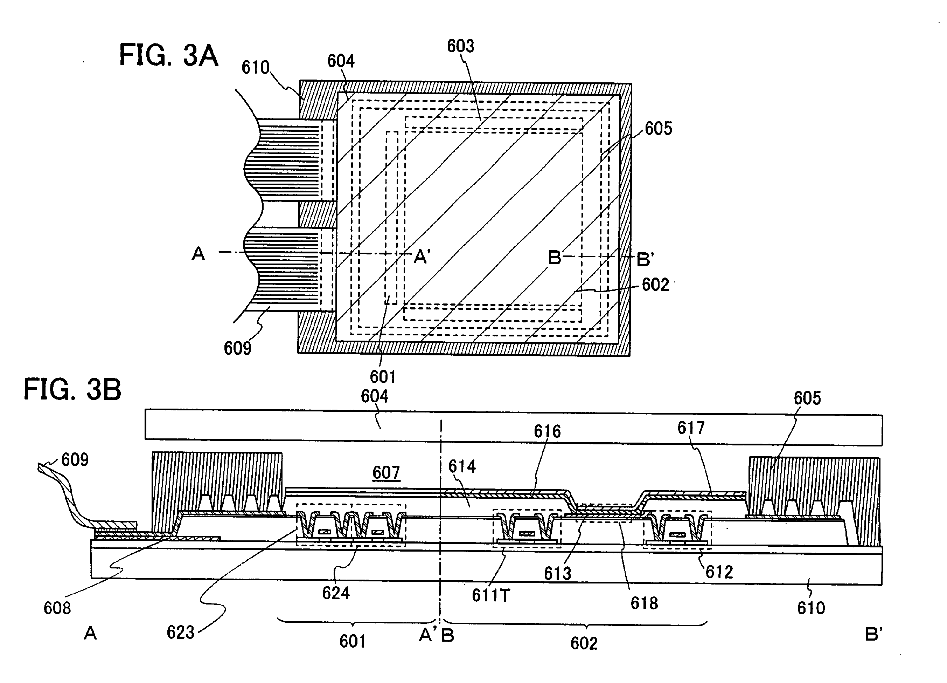

In this embodiment mode, an active light emitting device in which driving of a light emitting element is controlled by a transistor will be explained. A light emitting device having a light emitting element manufactured by applying the present invention to a pixel portion will be explained in this embodiment mode with reference to FIGS. 3A and 3B. FIG. 3A is a top view showing the light emitting device, and FIG. 3B is a cross-sectional view taken along lines A-A' and B-B' in FIG. 3A. Reference numeral 601 indicated by a dotted line denotes a driver circuit portion (a source side driver circuit); 602, a pixel portion; and 603, a driver circuit portion (a gate side driver circuit). Reference numeral 604 denotes a sealing substrate; 605, a sealant; and a portion surrounded by the sealant 605 is a space 607.

A lead wiring 608 is a wiring for transmitting a signal to be inputted to the source side driver circuit 601 and the gate side driver circuit 603, which receives a video signal, a clock signal, a start signal, a reset signal, or the like from an FPC (flexible printed circuit) 609 that is an external input terminal. It is to be noted that, although only the FPC is shown here, a printed wiring board (PWB) may be attached to the FPC. The light emitting device in this specification includes not only a light emitting device itself but also a light emitting device with an FPC or a PWB attached.

Subsequently, a cross-sectional structure will be explained with reference to FIG. 3B. The driver circuit portion and the pixel portion are formed over an element substrate 610. Here, the source side driver circuit 601 that is the driver circuit portion and one pixel in the pixel portion 602 are shown.

It is to be noted that a CMOS circuit which is a combination of an n-channel TFT 623 and a p-channel TFT 624 is formed as the source side driver circuit 601. A TFT for forming the driver circuit may be formed using a known CMOS circuit, a PMOS circuit, or an NMOS circuit. A driver integration type in which a driver circuit is formed over a substrate is described in this embodiment mode, but it is not necessarily required and a driver circuit can be formed outside a substrate, not over the substrate. The structure of the TFT is not limited in particular, and may be a staggered TFT or an inverted staggered TFT. Further, crystallinity of a semiconductor film to be used for a TFT is not limited in particular. An amorphous semiconductor film may be used, or a crystalline semiconductor film may be used. Furthermore, a semiconductor material is not limited in particular. An inorganic compound may be used, or an organic compound may be used.

The pixel portion 602 is formed using a plurality of pixels, each of which includes a switching TFT 611, a current control TFT 612, and a first electrode 613 which is electrically connected to a drain of the current control TFT 612. An insulator 614 is formed to cover an edge portion of the first electrode 613. Here, a positive type photosensitive acrylic resin film is used. It is to be noted that light emission of the light emitting element is controlled by the driver circuit, the switching TFT, and the current control TFT.

The insulator 614 is formed to have a curved surface having curvature at the upper edge portion or the lower edge portion thereof in order to make the coverage favorable. For example, in a case of using positive type photosensitive acrylic as a material of the insulator 614, the insulator 614 is preferably formed to have a curved surface with a curvature radius (0.2 to 3 µm) only at the upper edge portion of the insulator 614. Either a negative type which becomes insoluble in an etchant by light irradiation or a positive type which becomes soluble in an etchant by light irradiation can be used as the insulator 614.

An EL layer 616 and a second electrode 617 are formed over the first electrode 613. At least one of the first electrode 613 and the second electrode 617 has a light transmitting property, by which light emitted from the EL layer 616 can be extracted to outside.

The EL layer 616 has the layer including the composite material described in Embodiment Mode 1 and the light emitting layer described in Embodiment Mode 2.

As a formation method of the first electrode 613, the EL layer 616, and the second electrode 617, various methods can be employed. Specifically, a vacuum evaporation method such as a resistance heating evaporation method or an electron beam evaporation (EB evaporation) method, a physical vapor deposition method (PVD) such as a sputtering method, a chemical vapor deposition method (CVD) such as an organic metal CVD method or a hydride transfer low pressure CVD method, an atomic layer epitaxy method (ALE), or the like. Alternatively, an ink-jet method, a spin-coating method, or the like can be employed. A different film formation method for each electrode or each layer may be employed.

By attaching the sealing substrate 604 to the element substrate 610 with the sealant 605, a light emitting element 618 is provided in the space 607 surrounded by the element substrate 610, the sealing substrate 604, and the sealant 605. The space 607 is filled with a filler, but there is also a case where the space 607 is filled with the sealant 605 as well as a case where the space 607 is filled with an inert gas (nitrogen, argon, or the like).

It is to be noted that an epoxy-based resin is preferably used for the sealant 605. These materials desirably allow as little moisture and oxygen as possible to penetrate. As a material for the sealing substrate 604, a plastic substrate made of FRP (Fiberglass-Reinforced Plastics), PVF (polyvinyl fluoride), Myler, polyester, acrylic, or the like can be used as well as a glass substrate or a quartz substrate.

As described above, a light emitting device having a light emitting element manufactured by applying the present invention can be obtained.

The light emitting device described in this embodiment mode has the light emitting element described in Embodiment Modes 3 to 5. The light emitting element described in Embodiment Modes 3 to 5 can be operated at a low drive voltage. Further, high luminous efficiency can be realized. Accordingly, a light emitting device in which power consumption is reduced can be obtained.

A driver circuit with high withstand voltage is not required for the light emitting device described in this embodiment mode; therefore, a manufacturing cost of the light emitting device can be reduced. Further, the light emitting device can be lightweight, and a driver circuit portion can be miniaturized.

### [Embodiment Mode 8]

In this embodiment mode, an electronic appliance including the light emitting device described in Embodiment Modes 6 and 7 in part thereof will be explained. The electronic appliance described in this embodiment mode has the light emitting element described in Embodiment Modes 3 to 5, that is, a light emitting element in which a drive voltage is reduced. Therefore, an electronic appliance in which power consumption is reduced can be provided.

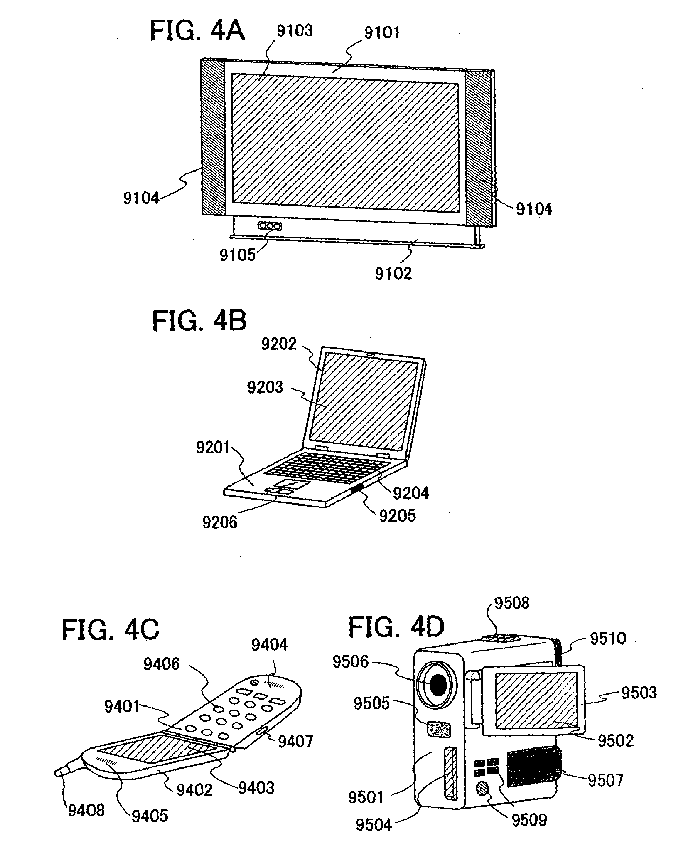

As an electronic appliance manufactured by applying the present invention, a camera such as a video camera and a digital camera, a goggle type display, a navigation system, an audio reproducing device (car audio set, audio component set, or the like), a computer, a game machine, a portable information terminal (mobile computer, mobile phone, portable game machine, electronic book, or the like), and an image reproducing device provided with a recording medium (specifically, a device provided with a display device that can reproduce a recording medium such as a Digital Versatile Disc (DVD) and display the image), and the like are given. Specific examples of these electronic appliances are shown in FIGS. 4A to 4D.

FIG. 4A shows a television device relating to this embodiment mode which includes a chassis 9101, a supporting base 9102, a display portion 9103, a speaker portion 9104, a video input terminal 9105, and the like. In the television device, the display portion 9103 has light emitting elements, which are similar to those described in Embodiment Modes 3 to 5, arranged in a matrix. The light emitting element has a feature that luminous efficiency is high and a drive voltage is low. In addition, a short-circuit due to impact from outside, or the like can be prevented. The display portion 9103 including the light emitting elements also has a similar feature. Therefore, in the television device, image quality is not deteriorated and low power consumption is attempted. With such a feature, a deterioration compensation functional circuit and a power supply circuit can be significantly reduced or the size thereof can be reduced in the television device; therefore, a small size and lightweight of the chassis 9101 and the supporting base 9102 can be attempted. In the television device relating to this embodiment mode, low power consumption, high image quality, and a small size and lightweight are attempted; therefore, a product which is suitable for living environment can be provided.

FIG. 4B shows a computer relating to this embodiment mode which includes a main body 9201, a chassis 9202, a display portion 9203, a keyboard 9204, an external connection port 9205, a pointing mouse 9206, and the like. In this computer, the display portion 9203 has light emitting elements, which are similar to those described in Embodiment Modes 3 to 5, arranged in a matrix. The light emitting element has a feature that luminous efficiency is high and a drive voltage is low. In addition, a short-circuit due to impact from outside, or the like can be prevented. The display portion 9203 including the light emitting elements also has a similar feature. Therefore, in this computer, image quality is not deteriorated and lower power consumption is attempted. With such a feature, a deterioration compensation functional circuit and a power supply circuit can be significantly reduced or the size thereof can be reduced in the computer; therefore, a small size and lightweight of the main body 9201 and the chassis 9202 can be attempted. In the computer relating to this embodiment mode, low power consumption, high image quality, and a small size and lightweight are attempted; therefore, a product which is suitable for environment can be provided. In addition, a computer which can be carried and has a display portion capable of withstanding impact from outside when being carried can be provided.

FIG. 4C shows a mobile phone relating to this embodiment mode which includes a main body 9401, a chassis 9402, a display portion 9403, an audio input portion 9404, an audio output portion 9405, an operation key 9406, an external connection port 9407, an antenna 9408, and the like. In the mobile phone, the display portion 9403 has light emitting elements, which are similar to those described in Embodiment Modes 3 to 5, arranged in a matrix. The light emitting element has a feature that luminous efficiency is high and a drive voltage is low. In addition, a short-circuit due to impact from outside, or the like can be prevented. The display portion 9403 including the light emitting elements also has a similar feature. Therefore, in the mobile phone, image quality is not deteriorated and lower power consumption is attempted. With such a feature, a deterioration compensation functional circuit and a power supply circuit can be significantly reduced or the size thereof can be reduced in the mobile phone; therefore, a small size and lightweight of the main body 9401 and the chassis 9402 can be attempted. In the mobile phone relating to this embodiment mode, low power consumption, high image quality, and a small size and lightweight are attempted; therefore, a product which is suitable for carrying can be provided. In addition, a product with a display portion which can withstand impact from outside when being carried can be provided.

FIG. 4D shows a camera which includes a main body 9501, a display portion 9502, a chassis 9503, an external connection port 9504, a remote control receiving portion 9505, an image receiving portion 9506, a battery 9507, an audio input portion 9508, an operation key 9509, an eye piece portion 9510, and the like. In the camera, the display portion 9502 has light emitting elements, which are similar to those described in Embodiment Modes 3 to 5, arranged in a matrix. The light emitting element has a feature that luminous efficiency is high, a drive voltage is low, and a short-circuit due to impact from outside, or the like can be prevented. The display portion 9502 including the light emitting elements also has a similar feature. Therefore, in the camera, image quality is not deteriorated and lower power consumption can be attempted. With such a feature, a deterioration compensation functional circuit and a power supply circuit can be significantly reduced or the size thereof can be reduced in the camera; therefore, a small size and lightweight of the main body 9501 can be attempted. In the camera relating to this embodiment mode, low power consumption, high image quality, and a small size and lightweight are attempted; therefore, a product which is suitable for carrying can be provided. In addition, a product with a display portion which can withstand impact from outside when being carried can be provided.

As described above, the applicable range of the light emitting device manufactured by applying the present invention is so wide that the light emitting device is applicable to electronic appliances in various fields. By applying the present invention, an electronic appliance having a display portion consuming low power and having high reliability can be manufactured.

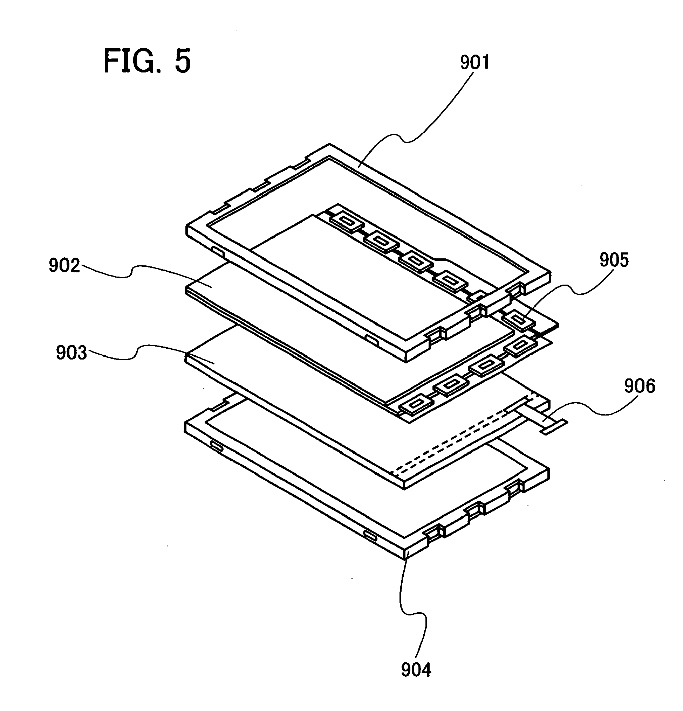

The light emitting device to which the present invention is applied has a light emitting element with high luminous efficiency, and can also be used as a lighting device. One mode using the light emitting element to which the present invention is applied as the lighting device will be explained with reference to FIG. 5.

FIG. 5 shows an example of a liquid crystal display device using the light emitting device to which the present invention is applied as a backlight. The liquid crystal display device shown in FIG. 5 includes a chassis 901, a liquid crystal layer 902, a backlight 903, and a chassis 904, and the liquid crystal layer 902 is connected to a driver IC 905. The light emitting device of the present invention is used for the backlight 903, and a voltage is applied by a terminal 906.

By using the light emitting device of the present invention as the backlight of the liquid crystal display device, a backlight with high luminance and long lifetime is obtained, which results in improvement of quality as a display device. The light emitting device of the present invention is a plane emission type light emitting device, and can have a large area. Therefore, the backlight can have a large area, and a liquid crystal display device can also have a large area. Furthermore, the light emitting element has a thin shape and consumes low power; therefore, a thin shape and low power consumption of a display device can also be achieved.

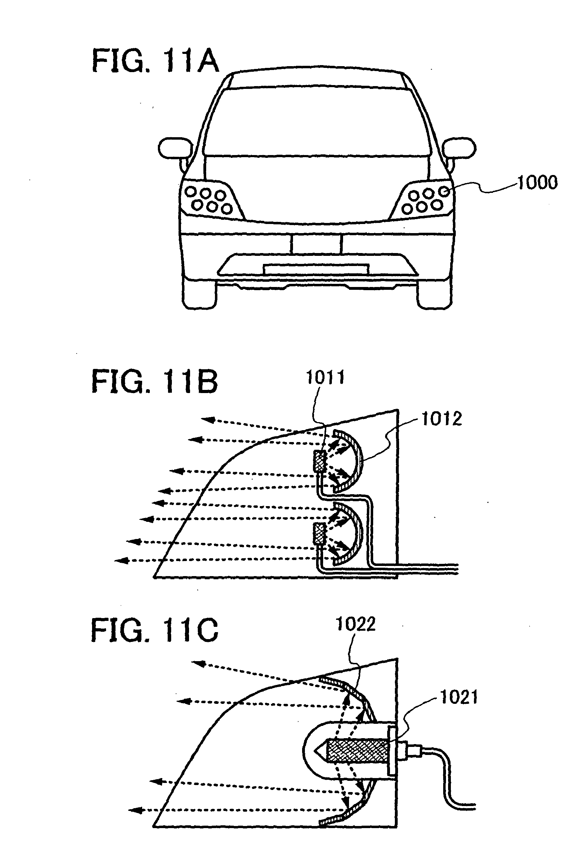

The light emitting device to which the present invention is applied can emit light with high luminance; therefore, the light emitting device can be used as a headlight of an automobile, a bicycle, a ship, or the like. FIGS. 11A to 11C each show an example in which the light emitting device to which the present invention is applied is used as a headlight of an automobile. FIG. 11B is a cross-sectional view in which a portion of a headlight 1000 in FIG. 11A is enlarged. In FIG. 11B, a light emitting device of the present invention is used as a light source 1011. Light emitted from the light source 1011 is reflected by a reflecting plate 1012 to be extracted to outside. With the use of a plurality of light sources as shown in FIG. 11B, light with higher luminance can be obtained. FIG. 11C shows an example in which the light emitting device of the present invention manufactured in a cylindrical shape is used as a light source. Light emitted from a light source 1021 is reflected by a reflecting plate 1022 to be extracted to outside.

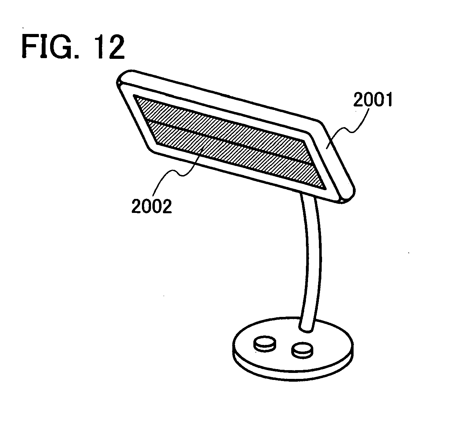

FIG. 12 shows an example in which the light emitting device to which the present invention is applied is used as a table lamp, which is a lighting device. A table lamp shown in FIG. 12 has a chassis 2001 and a light source 2002, and the light emitting device of the present invention is used as the light source 2002. The light emitting device of the present invention can emit light with high luminance; therefore, in a case or the like where fine manipulation is performed, the manipulator's hand can be brightly lighted.

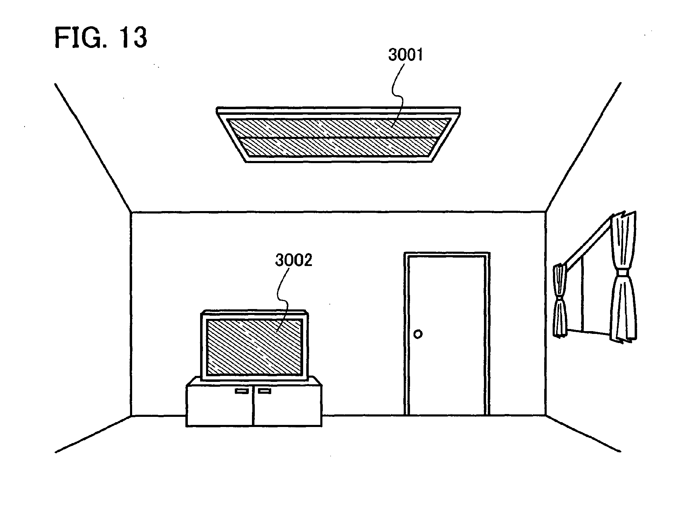

FIG. 13 shows an example in which the light emitting device to which the present invention is applied is used as an indoor lighting device 3001. Since the light emitting device of the present invention can have a large area, the light emitting device of the present invention can be used as a lighting device having a large area. Further, the light emitting device of the present invention has a thin shape and consumes low power; therefore, the light emitting device of the present invention can be used as a lighting device having a thin shape and consuming low power. A television device relating to the present invention as explained in FIG. 4A is placed in a room in which the light emitting device to which the present invention is applied is used as the indoor lighting device 3001 in such a manner. Thus, public broadcasting and movies can be watched. In such a case, since both of the devices consume low power, a powerful image can be watched in a bright room without concern about electricity charges.

A lighting device is not limited to that illustrated in FIGS. 11A to 11C, FIG. 12, and FIG. 13, and is applicable as a lighting device with various modes such as lighting for houses or public facilities. In such a case, in the lighting device relating to the present invention, since a light emitting medium having a thin film shape is used, the degree of freedom for design is high. Accordingly, variously-designed products can be provided in the market.
This application is based on Japanese Patent Application serial No. 2006-041636 filed in Japan Patent Office on February 17th, 2006, the entire contents of which are hereby incorporated by reference.

## Claims

1. A light emitting element comprising:
a light emitting layer and a layer including a composite material between a first electrode and a second electrode,
wherein the light emitting layer includes a base material and an impurity element which forms a luminescent center,
the layer including the composite material includes an organic compound and an inorganic compound,
the layer including the composite material is provided to be in contact with the second electrode, and
light emission is obtained by application of a voltage so that an electric potential of the second electrode is higher than an electric potential of the first electrode.

2. The light emitting element according to Claim 1,
wherein the organic compound is an aromatic amine compound.

3. The light emitting element according to Claim 1,
wherein the organic compound is a carbazole derivative.

4. The light emitting element according to Claim 1,
wherein the organic compound is aromatic hydrocarbon.

5. The light emitting element according to Claim 1,
wherein the inorganic compound shows an electron accepting property with respect to the organic compound.

6. The light emitting element according to Claim 1,
wherein the inorganic compound is transition metal oxide.

7. The light emitting element according to Claim 1,
wherein the inorganic compound is an oxide of a metal belonging to Groups 4 to 8 in a periodic table.

8. The light emitting element according to Claim 1,
wherein the inorganic compound is any of vanadium oxide, niobium oxide, tantalum oxide, chromium oxide, molybdenum oxide, tungsten oxide, manganese oxide, and rhenium oxide.

9. The light emitting element according to Claim 1,
wherein the base material is any of zinc sulfide, cadmium sulfide, calcium sulfide, yttrium sulfide, gallium sulfide, strontium sulfide, barium sulfide, zinc oxide, yttrium oxide, aluminum nitride, gallium nitride, indium nitride, zinc selenide, zinc telluride, calcium-gallium sulfide, strontium-gallium sulfide, and barium-gallium sulfide.

10. The light emitting element according to Claim 1,
wherein the impurity element is a metal element to be a luminescent center.

11. The light emitting element according to Claim 1,
wherein plural kinds of the impurity elements are included, which are a metal element to be a luminescent center; any one of fluorine (F), chlorine (Cl), bromine (Br), iodine (I), boron (B), aluminum (Al), gallium (Ga), indium (In), and thallium (Tl); and any one of lithium (Li), sodium (Na), potassium (K), rubidium (Rb), cesium (Cs), nitrogen (N), phosphorus (P), arsenic (As), antimony (Sb), and bismuth (Bi).

12. The light emitting element according to Claim 1,
wherein a metal element is included in a concentration of 0.05 to 5 atom% with respect to the base material.

13. The light emitting element according to Claim 1,
wherein the impurity element is a metal element selected from manganese, copper samarium, terbium, erbium, thulium, europium, cerium, and praseodymium.

14. The light emitting element according to Claim 1,
wherein plural kinds of the impurity elements are included, which are any one of copper, silver, gold, platinum, and silicon; and any one of fluorine, chlorine, bromine, iodine, boron, aluminum, gallium, indium, and thallium.

15. The light emitting element according to Claim 1,
wherein plural kinds of the impurity elements are included, which are any one of copper, silver, gold, platinum, and silicon; and any one of lithium, sodium, potassium, rubidium, cesium, nitrogen, phosphorus, arsenic, antimony, and bismuth.

16. The light emitting element according to Claim 1,
wherein plural kinds of the impurity elements are included, which are any one of copper, silver, gold, platinum, and silicon; any one of fluorine, chlorine, bromine, iodine, boron, aluminum, gallium, indium, and thallium; and any one of lithium, sodium, potassium, rubidium, cesium, nitrogen, phosphorus, arsenic, antimony, and bismuth.

17. The light emitting element according to Claim 1,
wherein a barrier layer is provided between the light emitting layer and the first electrode.

18. The light emitting element according to Claim 17,
wherein a thickness of the barrier layer is from 1 to 10 nm.

19. The light emitting element according to Claim 17,
wherein the barrier layer is metal oxide or metal nitride.

20. The light emitting element according to Claim 17,
wherein the barrier layer is an oxide of a metal included in the first electrode.

21. A light emitting device having the light emitting element according to Claim 1 and control means which controls light emission of the light emitting element.

22. An electronic appliance comprising a display portion,
wherein the display portion is equipped with the light emitting element according to Claims 1 and control means which controls light emission of the light emitting element.
